(19) Europäisches Patentamt
European Patent Office
Office européen des brevets

(11) EP 2 821 244 B1

(12) EUROPEAN PATENT SPECIFICATION

(45) Date of publication and mention
of the grant of the patent:
**16.09.2020 Bulletin 2020/38**

(51) Int Cl.:
***B43K 1/08*** *(2006.01)*    ***B43K 7/10*** *(2006.01)*

(21) Application number: **13755288.1**

(22) Date of filing: **19.02.2013**

(86) International application number:
**PCT/JP2013/053957**

(87) International publication number:
**WO 2013/129180 (06.09.2013 Gazette 2013/36)**

(54) **WRITING IMPLEMENT**

SCHREIBVORRICHTUNG

INSTRUMENT D'ÉCRITURE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.02.2012 JP 2012040305**

(43) Date of publication of application:
**07.01.2015 Bulletin 2015/02**

(73) Proprietors:
• **Kabushiki Kaisha Pilot Corporation**
  **Tokyo 104-8304 (JP)**
• **THE PILOT INK CO., LTD.**
  **Nagoya-shi, Aichi 466-8588 (JP)**

(72) Inventors:
• **TOYOTA, Kunihiro**
  **Hiratsuka-shi**
  **Kanagawa 254-8585 (JP)**

• **SEKINE, Nobuo**
  **Nagoya-shi**
  **Aichi 466-8588 (JP)**

(74) Representative: **Elkington and Fife LLP**
**Prospect House**
**8 Pembroke Road**
**Sevenoaks, Kent TN13 1XR (GB)**

(56) References cited:
JP-A- 2001 121 868    JP-A- 2003 196 819
JP-A- 2004 338 134    JP-A- 2004 338 134
JP-A- 2005 324 336    JP-A- 2005 324 336
JP-A- 2010 240 931    JP-A- 2012 012 329
JP-A- 2012 056 198    JP-A- 2012 056 198

EP 2 821 244 B1

**Description**

Technical Field

The present invention relates to writing instruments. Specifically, the present invention relates to a writing instrument including a pen point retaining member, a pen point that is attached to a first end of the pen point retaining member, and an ink tank that is releasably attached to a second end of the pen point retaining member.

Background Art

A writing instrument with an interchangeable ink tank, in which an ink reservoir member is placed between a pen point and an ink tank and an ink tank is releasably attached at the back of the ink reservoir member, has been conventionally known (for example, Patent Literature 1). Patent Literature 1 describes a writing instrument in which a pen point (ball-point pen tip) is releasably and interchangeably attached to an ink reservoir member and appropriate writing performance can be maintained for a long term by exchanging the pen point for a new pen point when the pen point is worn.

The writing instrument with an interchangeable ink tank described in Patent Literature 1, in which each of the pen point and the ink tank can be exchanged, can be used for a long term. However, the writing instrument has had such a point to be improved that the operation of exchanging the pen point has been trouble for users, writing performance may be deteriorated by incomplete attachment of the pen point (attachment error) by the user, or the writing instrument has been uneconomical for the user. Further, the writing performance has been prone to be deteriorated by the wear of the inner surface of a ball holding portion (specifically, the inner surface of a leading edge, and a portion coming into contact with the ball in the inner surface of each inwardly projecting portion) due to the rotation of a ball when the pen point has been a ball-point pen tip, whereby the writing instrument has been also susceptible to improvement in view of durability.

Use of a ceramic ball, coating of the surface of a metallic ball with a rigid material such as a diamond-like carbon film for reducing the wear of the ball and the ball holding portion (for example, Patent Literature 2), and the like have been attempted with respect to such problems. Coating of the surface of not only the ball but also the ball holding portion with a rigid material for reducing the wear of the ball holding portion by the ball has been also attempted.

Citation List

Patent Literature

Patent Literature 1: Japanese Patent Laid-Open No. 2005-324336
Patent Literature 2: Japanese Patent Laid-Open No. 2004-338134

JP 2010 240931 discloses a ball-point pen tip which is provided with a chip body and a valve mechanism. A lubricant covered layer is formed on the surface of the ball, and a transferred lubricant layer is provided between the ball and the coil spring.

SUMMARY OF INVENTION

Technical Problem

However, even when only the hardness of a ball or a ball holding portion is increased as in Patent Literature 2, it is difficult to prevent the ball and the ball holding portion from being worn to realize sufficient durability. This is because when the contact site between the ball and the ball holding portion is microscopically observed, the contact site may be in the state of boundary lubrication in which the ball and the ball holding portion come into direct contact with each other without the existence of an ink for a writing instrument in the interface between the ball and the ball holding portion. Such a phenomenon has tended to be prone to occur particularly when such an ink as to have a low viscosity of 10 mPa·s or less (20°C) has been used. Further, handwriting or a drawn line has been prone to be nonuniform in such a case, so that the case has been susceptible to improvement.

The present invention is to provide a writing instrument with an interchangeable ink tank, in which stable writing performance can be maintained for a long term, and a feeling of writing and handwriting are favorable, while a pen point structure that has been conventionally considered to be prone to have insufficient durability is adopted.

Solution to Problem

The writing instrument according to the present invention is a writing instrument comprising: a pen point retaining member; a pen point that comprises a ball and a ball holding portion that rotatably holds the ball, and is attached to a first end of the pen point retaining member; and an ink tank that is releasably attached to a second end of the pen point retaining member, wherein a carbonaceous film is formed on at least one of a surface of the ball or a contact portion of the ball holding portion with the ball; and the carbonaceous film comprises carbon and oxygen bound to the carbon, said ink tank accommodates a water-based ink, wherein a ratio of a bond containing oxygen to the total bonded carbon contained in the carbonaceous film is 0.1 or more and 0.5 or less.

Advantageous Effects of Invention

In accordance with the present invention, problems caused by exchanging of a pen point are solved by eliminating the need for exchanging the pen point, stable writing performance can be maintained for a long term, and a feeling of writing and handwriting can be kept favorable, in a writing instrument with an interchangeable ink tank, in which a ball-point pen tip is adopted as the pen point. Furthermore, the writing instrument according to the present invention enables the pen point and the pen point retaining member to be repeatedly used, to thereby have a small load to the environment compared to conventional disposable ball-point pen.

BRIEF DESCRIPTION OF DRAWINGS

[Figure 1] Figure 1 is a longitudinal cross-sectional view of a writing instrument according to an embodiment of the present invention.
[Figure 2] Figure 2 is a cross-sectional view of the line A-A of Figure 1.
[Figure 3] Figure 3 is an enlarged vertical longitudinal sectional view of the principal portion of Figure 1.
[Figure 4] Figure 4 is a view indicating the contact angles between balls and an ink for a writing instrument.

DESCRIPTION OF EMBODIMENTS

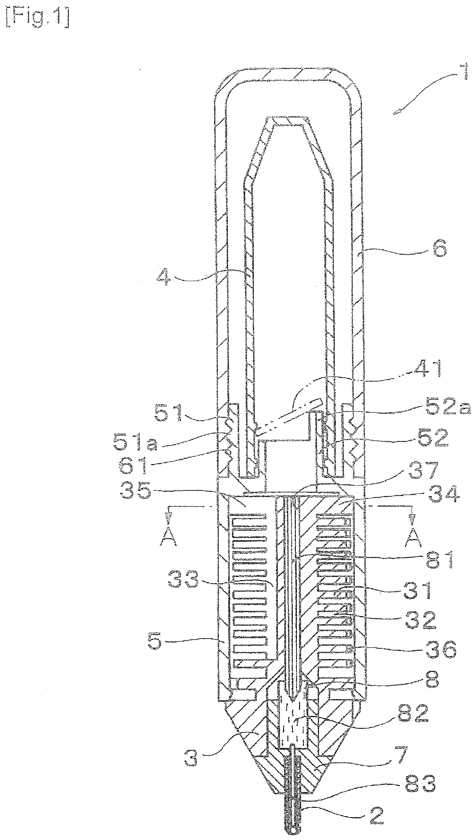

An embodiment of the writing instrument according to the present invention will be explained in detail below with reference to the drawings.
The cross-sectional view of the writing instrument according to one embodiment of the present invention is as illustrated in Figure 1. The writing instrument 1 is a direct liquid type writing instrument, in which a pen point 2 and an ink tank 4 are attached to both ends of a pen point retaining member 3. On the pen point retaining member 3, combs 31 in which an ink effused due to the increase of the internal pressure of the ink tank 4 is temporarily retained are formed. Reservation grooves 32 and a guiding groove 33 are defined by the combs 31, so that the function of reserving an ink is exerted. The ink tank 4 is attached to a rear end side when the pen point side of the writing instrument 1 is regarded as a leading end side; in the present invention, the ink tank 4 is releasably attached, and the writing instrument 1 is a writing instrument with an interchangeable ink tank.
The writing instrument 1 illustrated in Figure 1 further includes a leading shaft 5 and a rear shaft 6. The leading shaft 5 accommodates the pen point retaining member 3, and a threaded engagement structure for releasably attaching the rear shaft 6 is disposed in the rear end portion thereof. A structure to which the ink tank 4 is releasably attached is disposed in the rear end side of the pen point retaining member accommodated in the leading shaft 5. In the writing instrument illustrated in Figure 1, the rear end of the leading shaft 5 described below protrudes to form a cylindrical binding portion 52, to which the ink tank 4 is releasably connected. The ink tank 4 is accommodated in the rear shaft 6 by attaching the rear shaft 6. The pen point 2 is attached to the leading end of the pen point retaining member 3 via a holder 7. An ink is guided from the ink tank 4 to the pen point 2 by an ink guiding member 8 which penetrates the pen point retaining member 3.

Leading Shaft

The leading shaft 5 includes a cylindrical structure, of which both ends are opened, for example, a hollow cylinder, and is obtained by injection molding or the like of a synthetic resin (for example, polypropylene, polycarbonate, or the like). The rear end portion of the leading shaft 5 is provided with a cylindrical threaded engagement portion 51, of which the diameter is reduced, and the cylindrical binding portion 52 which is concentrically placed on the inside of the threaded engagement portion 51. A male screw portion 51a is formed on the outer surface of the threaded engagement portion 51. The binding portion 52 is pressed into the opening of the ink tank 4 when the ink tank 4 is attached. Furthermore, a projection 52a for backward pushing off a plug body 41 in the opening of the ink tank 4 to open the plug when the ink tank 4 is attached is formed in a part of the rear end of the binding portion 52.

Rear Shaft

The rear shaft 6 includes a bottomed cylindrical body, of which the leading end side is opened, and is obtained by injection molding or the like of a synthetic resin (for example, polypropylene, polycarbonate, or the like). A female screw portion 61 that can be threadedly engaged releasably with the male screw portion 51a of the threaded engagement portion 51 of the leading shaft 5 is formed on the inner peripheral surface of the leading end side opening of the rear shaft 6. Further, the rear shaft 6 preferably has transparency so that the amount of residual ink in the ink tank 4 can be viewed from the outside.

·Pen Point Retaining Member

The pen point retaining member 3 is obtained by injection molding or the like of a synthetic resin (for example, ABS resin or the like). The pen point 2 and the ink tank 4 are attached to the pen point retaining member 3. The ink tank 4 is attached releasably. In contrast, the pen point 2 is unreleasably attached in the writing instrument illustrated in Figure 1. In other words, in the present invention, since the durability of the pen point is high, there is no need for exchanging the pen point, and therefore, it is not necessary to allow the pen point to be releasable. However, the pen point can also be releasably attached to be intended to be used for a longer term.

In the present invention, the pen point retaining member 3 has the function of linking the ink tank to the pen point. In order to realize a higher writing property, the pen point retaining member is preferably provided with an ink reserving function. The writing instrument illustrated in Figure 1 includes the pen point retaining member having the ink reserving function.

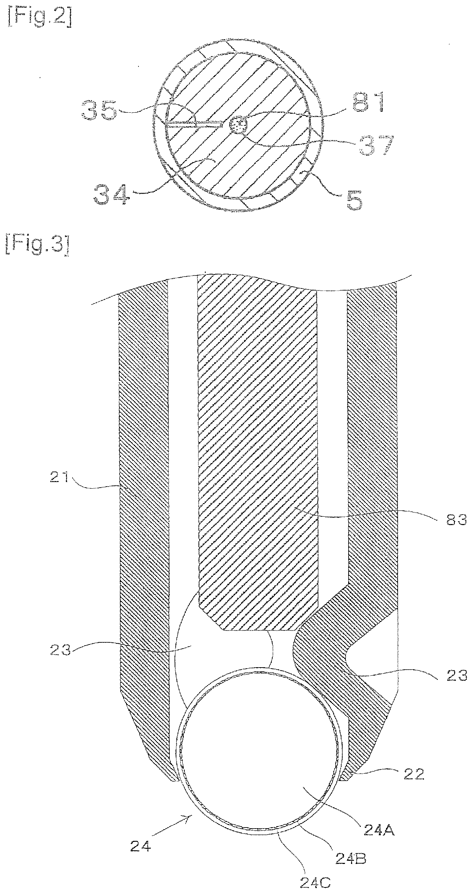

The pen point retaining member 3 includes the plural combs 31 which are discoidal. The reservation grooves 32 for temporarily reserving an ink are formed mutually between the combs 31. The slit-like guiding groove 33 that is connected to each reservation groove 32 and extends in an axial direction is formed on the combs 31. A communication groove 35 which is connected to the guiding groove 33 and of which the side closer to the ink tank 4 is opened is installed to penetrate back and forth a collar portion 34 located at the rearmost end of the group of the combs 31 of the pen point retaining member 3 (see Figure 2). Further, concave grooves 36 for circulating air are formed on the combs 31. Further, a central hole 37 is installed to penetrate the center of the pen point retaining member 3. A first ink guiding member 81 including an extrusion-molded body of a synthetic resin is attached by being inserted into the central hole 37.

The member having the ink reserving function of temporarily retaining an ink effused due to the increase of the internal pressure of the ink tank was described as an example of the pen point retaining member, but the pen point retaining member is not particularly limited thereto.

·Ink Tank

In the writing instrument illustrated in Figure 1, the ink tank 4 is obtained by injection-molding or the like of a synthetic resin (for example, polyethylene or the like). The ink tank 4 is generally a bottomed cylindrical body of which the leading end is opened and the rear end is closed, and in which the inner peripheral surface of the opening is provided with the plug body 41, which blockades the interior of the ink tank 4, by fitting, welding, adhering, or the like. An ink for a writing instrument is accommodated directly in the ink tank 4. The ink tank 4 preferably has transparency so that the amount of residual ink therein can be viewed.

Although the direct liquid type writing instrument in which ink is accommodated directly in the ink tank is described as an example in Figure 1, an inner cotton type writing instrument in which inner cotton is impregnated with ink is also acceptable.

Further, examples of the ink used in the writing instrument according to the present invention include water-based inks, water-based gel inks, and the like, without particular limitation. Among these inks a water-based ink with Newtonian viscosity or a water-based ink imparted with shear-thinning viscosity are preferred since the effect of improvement in durability by the present invention is prominently produced. As a reason for that, if such ink is used, the contact portion between the ball and the ball holding portion generally tends to become in boundary lubrication to be prone to be worn, the effect of the present invention can be enhanced. Furthermore, the viscosity of the ink used in the present invention is not also particularly limited, but the case of using an ink having a viscosity of less than 10 mPa·s (20°C) in writing is also preferred since the effect of the present invention is similarly prominently produced.

Further, the ink used in the writing instrument according to the present invention desirably has a high affinity for a carbonaceous film. For example, an ink used in a ball-point pen often contains water and a component having a hydrophilic functional group, such as alcohol or glycol ether. The ink containing such a component has a low affinity for a conventionally used ball, for example, a ball comprising silicon carbide, which is not subjected to surface treatment. Therefore, a contact portion between a ball and a ball holding portion tends to be prone to be in boundary lubrication. However, in the present invention, the carbonaceous film having a carbon-oxygen bond is formed on either ball or ball holding portion, and it is easy to offer fluid lubrication between the ball and the ball holding portion by using an ink having a high affinity therefor. The affinity of the ink for such a carbonaceous film can be evaluated by a contact angle. In the present invention, in particular, the contact angle of the ink with respect to the carbonaceous film is preferably 55° or less, more preferably 30° or less.

·Pen Point

The pen point 2 has a structure in which a ball 24 is rotatably held in the ball holding portion disposed in the leading end. Such a structure is also referred to as a ball-point pen tip. In the ball holding portion, the ball 24 is rotatably held by an inward leading edge 22 formed by radially inwardly press-deforming the taper-like leading end portion of a metallic pipe 21 (for example, a pipe comprising stainless steel, copper, aluminum, nickel, or the like), and by a plurality of (for example, three or four) inwardly projecting portions 23 formed by radially inwardly press-deforming a side wall in the vicinity of the leading end of the pipe. The plural inwardly projecting portions 23 are placed generally at an equal spacing circumferentially on the inner surface of the pipe 2. The ball is held by the extremely leading end portion 22 and the inwardly projecting portions 23 so as not to be removed from the pen point.

Although the pipe-type ball-point pen tip formed by press-processing or the like of a pipe made of stainless steel is illustrated as an example in Figure 1, a cutting-type ball-point pen tip formed by cutting and processing a stainless steel wire rod with a drill is also acceptable. Examples of the material of the ball 24 include sintered bodies of tungsten carbide, ceramics of zirconia, alumina, silica, silicon carbide, and stainless steel.

As the material of the ball held by the pen point, which is not particularly limited, a material comprising a metal or a ceramic is generally used. Since durability is demanded in the writing instrument according to the present invention, it is preferable to select a material having a high hardness. For example, a ceramic such as tungsten carbide, zirconium oxide, aluminum oxide, silicon oxide, or silicon carbide, or a metal such as stainless steel is used. A cemented carbide alloy comprising a ceramic and a metallic binding material may also be used. As such a cemented carbide alloy, an alloy comprising tungsten carbide and a metallic binding material such as cobalt or nickel is known.

In the writing instrument illustrated in Figure 1, the ball of tungsten carbide (equivalent to ISO K-10) having a diameter of 0.5 mm is used. The size of the ball is determined by the application of the writing instrument, the width of a drawn line demanded in writing, or the like, and is generally selected from the range of 0.25 to 2.0 mm.

·Carbonaceous Film

In the writing instrument according to the present invention, a carbonaceous film is formed on at least one of the surface of the ball or the contact portion of the ball holding portion with the ball. The carbonaceous film may be formed on both of the surface of the ball and the contact portion. In Figure 3, an example in which a carbonaceous film 24C is formed on the surface of a ball body 24A via an intermediate layer 24B (detailed below) is illustrated. In the present invention, a material including the ball body 24A as well as the intermediate layer 24B and the carbonaceous film 24C may be referred to as a ball. When the carbonaceous film is formed on the ball holding portion, the carbonaceous film may be formed only on a part coming into contact with the ball, while the carbonaceous film may also be formed in a wider range than the actual contact part from the viewpoint of the easiness of production, deformation due to use, and the like. Furthermore, the carbonaceous film may be formed on the whole inner surfaces of the ball holding portion.

In the present invention, the carbonaceous film has a carbon atom and an oxygen atom bound to the carbon atom. Therefore, the durability of the ball or the ball holding portion is increased. In addition, since the carbonaceous film in the present invention has a high affinity for an ink, the ink is held in a gap between the ball and the interior of the ball holding portion, and direct contact between the ball and the ball holding portion is inhibited. As a result, the wear of the ball and the interior of the ball holding portion due to the direct contact between the ball and the ball holding portion can be reduced, and the durability is further improved. In addition, since the deterioration of the feeling of writing due to use is inhibited by the improvement in durability, the need for exchanging the pen point is substantially eliminated, and a ball-point pen in which stable writing performance is satisfied for a long term can be realized. Further, when the carbonaceous film is formed on the ball surface, an affinity between the ball surface and ink is improved to thereby enable the stabilization of the supply of the ink to a contact portion between the ball and a paper surface during writing, therefore, more uniform handwriting and the favorable feeling of writing can be realized, and a writing property can be allowed to be favorable.

In the carbonaceous film, a carbon atom is bound to an oxygen atom in various forms. Specifically, a carbon atom and an oxygen atom are considered to be bound to each other in the forms of C-O, O=C-O, and C=O. It is considered that C-O mainly constitutes hydroxyl group, ethers, and the like, C=O mainly constitutes carbonyl group, ketones, and the like, and O=C-O mainly constitutes carboxyl group, esters, and the like in general. These bonds are considered to enhance hydrophilicity. In addition, a carbon atom is bound to carbon or hydrogen in the form of C-C or C-H. Accordingly, hydrophilicity on the surface of the carbonaceous film is increased to enhance the affinity between the carbonaceous film and an ink by increasing the rate (hereinafter referred to as $CO_{total}$) of bonds containing oxygen (C-O, O=C-O, and C=O) to all the bonds of carbon (C-O, O=C-O, C=O, C-C, and C-H). A value of $CO_{total}$ is preferably 0.1 or more and more preferably 0.15 or more since the affinity between the carbonaceous film and the ink is increased, and it is easy to maintain stable writing performance for a long term and over a long distance. In contrast, since the excessively high value of $CO_{total}$ tends to result in reduced bonds between carbon atoms and in decreased hardness, the value is preferably 0.5 or less and more preferably 0.45 or less.

In the present invention, the carbonaceous film can be formed on the ball surface or the contact portion of the ball holding portion with the ball by an optional method. The carbonaceous film may be formed on either or both of the ball surface or the ball holding portion. However, since the formation of the carbonaceous film on the ball surface results in the reduction of wear between the ball and the ball holding portion and in the stabilization of the supply of ink as described above, it is preferable to form the carbonaceous film on at least the ball surface.

A method of forming the carbonaceous film is not particularly limited. For example, the formation can be performed by a plasma chemical vapor phase deposition method (plasma CVD method), a catalytic chemical vapor phase deposition method (CAT-CVD method), or the like using hydrocarbon gas as a raw material. The formation can also be performed by a sputtering method, an arc ion plating method, or the like with solid graphite as a raw material. Furthermore, the formation may be performed by another method or by a combination of a plurality of methods.

The carbonaceous film used in the present invention is a film containing an $sp^2$ carbon-carbon bond (graphite bond) and an $sp^3$ carbon-carbon bond (diamond bond), which film is represented by a diamond like film (DLC film). A film in an amorphous state, such as a DLC film, or a film in a crystalline state, such as a diamond film, is acceptable. However, in the carbonaceous film in the present invention, a higher proportion of an $sp^3$ carbon-carbon bond to an $sp^2$ carbon-carbon bond is preferred since the hardness of the carbonaceous film is higher. Specifically, the proportion of the $sp^3$ carbon-carbon bond to the $sp^2$ carbon-carbon bond is preferably 0.3 or more.

Further, although the carbonaceous film typically contains an $sp^2$ carbon-hydrogen bond and an $sp^3$ carbon-hydrogen bond, a carbon-hydrogen bond is not an essential component in the carbonaceous film in the present invention. To the carbonaceous film, silicon (Si), fluorine (F), or the like may also be added in a range in which the effect of the present invention is not deteriorated.

Further, a method of introducing a carbon-oxygen bond into the carbonaceous film may be performed by irradiation with, for example, oxygen plasma, plasma of a gas containing oxygen, or the like. As the gas containing oxygen, water vapor, air, or the like can be used. A gas of an organic substance compound containing an oxygen atom, or the like can also be used. Furthermore, oxygen can also be introduced by irradiating the carbonaceous film with ultraviolet rays in an atmosphere containing oxygen or by immersing the carbonaceous film in an oxidative solution. When the carbonaceous film is formed, a carbon-oxygen bond can also be introduced by increasing the concentration of oxygen in an atmosphere when the carbonaceous film is formed. Just after the formation of the carbonaceous film, a free bond exists on the surface thereof. Therefore, the free bond can also be allowed to react with oxygen to introduce a carbon-oxygen bond by leaving the carbonaceous film, just after having been formed, standing in an atmosphere containing oxygen. A carbon atom with a free bond may also exist if a carbon-oxygen bond is introduced.

The film thickness of the carbonaceous film is not particularly limited but preferably ranges from 0.001 $\mu$m to 3 $\mu$m, more preferably ranges from 0.005 $\mu$m to 1 $\mu$m. Further, the carbonaceous film can be formed directly on the surface of the ball or the ball holding portion; however, in order to allow the ball or the ball holding portion and the carbonaceous film to more firmly adhere to each other, it is preferable to dispose an intermediate layer. As the material of the intermediate layer, various materials can be used depending on the kind of the ball or the ball holding portion, and, for example, a known material such as an amorphous film comprising silicon (Si) and carbon (C), titanium (Ti) and carbon (C), or chromium (Cr) and carbon (C) can be used. The thickness thereof is not particularly limited but preferably ranges from 0.001 $\mu$m to 0.3 $\mu$m and more preferably ranges from 0.005 $\mu$m to 0.1 $\mu$m. The intermediate layer can be formed by using, for example, a sputtering method, a CVD method, a plasma CVD method, a spraying method, an ion plating method, an arc ion plating method, or the like.

The pen point 2 is attached to the front of the holder 7. In addition, the rear of the holder 7 is pressed into the leading end opening of the central hole 37 of the ink retaining member 3. In other words, the pen point 2 is attached to the ink retaining member 3 via the holder 7. The holder 7 includes a collar-like front, to which the pen point 2 is attached, and a rear pressed into the leading end opening of the central hole 37 of the ink retaining member 3. The holder 7 is obtained by injection-molding or the like of a synthetic resin or the like.

The ink guiding member 8 includes the first ink guiding member 81, a second ink guiding member 82, and a third ink guiding member 83. The second ink guiding member 82 including a fiber-processed body is accommodated in the rear of the holder 7. The third ink guiding member 83 which guides ink to the rear face of the ball 24 and includes an extrusion-molded body of a synthetic resin is accommodated in the pen point 2. The rear end of the third ink guiding member 83 intrudes into and is connected to the leading end of the second ink guiding member 82, while the leading end of the first ink guiding member 81 intrudes into and is connected to the rear end of the second ink guiding member 82. The third ink guiding member 83 is allowed to abut on the inner surface (rear inner surface) of each inwardly projecting portion 23.

Method for Forming Carbonaceous Film

In the writing instrument according to the present invention, the carbonaceous film is formed on at least one of the ball or the ball holding portion. A method of forming a carbonaceous film will be explained below. As an example, a method of forming a carbonaceous film on a ball surface will be explained. A similar method can also be applied to the case of forming a carbonaceous film on a ball holding portion.

Prior to the formation of the carbonaceous film on the ball surface, an intermediate layer can be formed. The case of forming an intermediate layer including an amorphous film containing Si and C on the surface of the ball will be explained. For the film formation of the intermediate layer, for example, an ionic vapor deposition method can be used. In the method, the interior of a chamber for ionized deposition is adjusted to predetermined pressure using a vacuum pump, tetramethylsilane ($Si(CH_3)_4$) is introduced into the chamber, and a bias voltage (for example, 1 kV) is applied to the ball to cause discharge (for, e.g., 30 minutes). The intermediate layer can be formed on the whole surface of the ball by rotating the ball in the chamber when the film is formed.

After the formation of the intermediate layer, the gas supplied into the chamber is switched to benzene to form the carbonaceous film. The interior of the chamber is adjusted to predetermined pressure using a vacuum pump, and a bias voltage (for example, 1 kV) is thereafter applied to the ball to cause discharge (for, e.g., 90 minutes). The carbonaceous film can be formed on the whole surface of the ball by rotating the ball in the chamber when the film is formed.

Thereafter, plasma irradiation is performed in an atmosphere containing oxygen to introduce a carbon-oxygen bond into the carbonaceous film. Plasma irradiation is performed at a pressure adjusted to, for example, 100 Pa in the chamber and at an output of, for example, 10 W, whereby the ball of interest can be obtained.

The rate of the carbon-oxygen bond contained in the obtained carbonaceous film can be evaluated by X-ray photoelectron spectroscopy (XPS) measurement. Measurement conditions are adjusted depending on the kind, thickness, and the like of a carbonaceous film to be formed, for example, a detection angle with respect to a sample can be 90°, Al can be used as an X-ray source, and X-ray irradiation energy can be 100 W. Time of one measurement is generally around 0.1 ms. Further, in order to enhance measurement accuracy, measurement of one sample may be performed several times, for example, 64 times to regard the average value thereof as a measurement result.

In order to determine the rates of C-O, C=O, and O=C-O in the carbonaceous film, a carbon 1s (C1s) peak obtained by the XPS measurement is decomposed, by curve fitting, into seven components of $sp^3$ C-C and $sp^2$ C-C in which carbon and carbon are bound to each other, $sp^3$ C-H and $sp^2$ C-H in which carbon and hydrogen are bound, and C-O, C=O, and O=C-O in which carbon and oxygen are bound. It is appropriate for the curve fitting to allow the bond energy of $sp^3$ C-C to be 283.8 eV, the bond energy of $sp^2$ C-C to be 284.3 eV, the bond energy of $sp^3$ C-H to be 284.8 eV, the bond energy of $sp^2$ C-H to be 285.3 eV, the bond energy of C-O to be 285.9 eV, the bond energy of C=O to be 287.3 eV, and the bond energy of O=C-O to be 288.8 eV. A value obtained by dividing the area of each peak obtained by the curve fitting by the overall area of the C1s peak is regarded as the composition ratio of each component. The sum of the composition ratios of C-O, C=O, and O=C-O is regarded as the rate ($CO_{total}$) of carbon-oxygen-bound carbon atoms to the total carbon atoms.

The thicknesses of the intermediate layer and the carbonaceous film can be measured by analyzing the ball, on which the carbonaceous film is formed, with an Auger electron spectroscopy device (PHI-660 Type (trade name), manufactured by ULVAC-PHI, Inc.). Specifically, the surface of the ball on which the carbonaceous film is formed is etched in stages, and the surface is analyzed at each stage by an Auger electron spectroscopy analysis method. As measurement conditions, for example, the acceleration voltage of an electron gun is set at 10 kV, a sample current is set at 500 nm, and the acceleration voltage of an argon ion gun is set at 2 kV. A region measuring 40 μm per side on the ball surface is analyzed at each depth under the measurement conditions, whereby the thicknesses of the intermediate layer and the carbonaceous film can be measured.

When a ball with a carbonaceous film produced by the method was analyzed, the following results were obtained. In the depth from the surface of the ball, on which the carbonaceous film was formed, to around 80 nm, only carbon atoms (C) substantially existed, and the carbonaceous film was formed. In the depth of 80 nm to 120 nm, Si atoms existed, and an intermediate layer comprising SiC was formed. In the portion having a depth of 100 nm or more, only tungsten carbide (WC) was detected, and the intermediate layer and the carbonaceous film were confirmed to be formed on the surface of the tungsten carbide which was the ball.

Example

A ball (DLC-1) on the ball surface of which a carbonaceous film was formed and a ball (DLC-2) in which a carbonaceous film in which the rate of carbon-oxygen bond was varied by changing plasma irradiation conditions was obtained were produced by the method. Specifically, DLC-1 was irradiated with oxygen plasma for 60 seconds at an output of 10 W from a high frequency power source. DLC-2 was irradiated with oxygen plasma for 60 seconds at an output of 50 W from the high frequency power source. The rate of each bond contained in the carbonaceous films formed on the balls was measured by the method. The obtained results are as listed in Table 1.

[Table 1]

Table 1

| | C-C + C-H | C-O | C=O | O=C-O | $CO_{total}$ | $\frac{sp^3\ C\text{-}C}{sp^2\ C\text{-}C}$ |
|---|---|---|---|---|---|---|
| DLC-1 | 0.84 | 0.13 | 0.02 | 0.01 | 0.16 | 0.39 |
| DLC-2 | 0.57 | 0.21 | 0.13 | 0.09 | 0.43 | 0.42 |

The proportions ($CO_{total}$) of carbon atoms bound to oxygen atoms with respect to the total carbon atoms in DLC-1 and DLC-2 were 0.16 and 0.43, respectively. The value of $CO_{total}$ in DLC-2 with the higher power output in the irradiation with oxygen plasma was higher than that in DLC-1. $CO_{total}$ is further detailed as follows: the proportions of C-O to the total carbon in DLC-1 and DLC-2 were similar, while the proportion of C=O in DLC-2 was about 6 times that in DLC-1, and the proportion of O=C-O in DLC-2 was about 9 times that in DLC-1. Further, the proportions of $sp^3$ carbon-carbon bonds to $sp^2$ carbon-carbon bonds in the carbonaceous films were 0.3 or more.

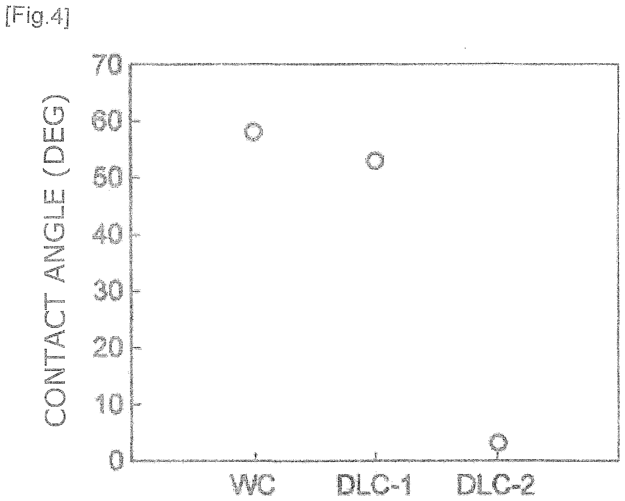

Then, a contact angle between the surface of each ball of a tungsten carbide ball (WC) on which no carbonaceous film was formed, DLC-1 described above, or DLC-2 described above, and an ink for a writing instrument was measured. The obtained results are as listed in Figure 4. The measurement was performed using a water-based ink for a writing instrument comprising water, an organic solvent, and a coloring agent (water soluble dye) (manufactured by PILOT CORPORATION, having an ink viscosity of 2 mPa·s under an environment at 20°C) as the ink for a writing instrument. The measurement of viscosity was performed using a digital viscometer (DV-II: CPE-42 ROTOR, manufactured by Brookfield Engineering Laboratories, Inc.).

A contact angle of around 60° in the untreated WC ball is decreased to around 55° in DLC-1 and to around 3° in DLC-2, so that it is found that the affinities thereof are very high. It is clear that an affinity for an ink for a writing instrument is improved by forming a carbonaceous film having a carbon-oxygen bond.

For the measurement of a contact angle, an automatic contact angle measuring machine (DM-500 (trade name) manufactured by Kyowa Interface Science Co., Ltd.) was used. Dropwise addition of 1 μl of the water-based ink onto the surface of a test plate (WC, equivalent to ISO K-10) having a carbonaceous film disposed under the same conditions as those of the carbonaceous film disposed on the ball was performed to measure a contact angle. The timing of the measurement was just after the dropwise addition, and the measured value was an average value at three points. In the case of an ink having a comparatively high viscosity, for example, in the case of a water-based gel ink or an oil-based ink, the contact angle can be determined by measurement performed 3 seconds after the dropwise addition (measured value was an average value at three points).

The surface tension of the water-based ink was 40 mN/m. The surface tension of an ink is preferably 20 mN/m or more and 40 mN/m or less, most preferably 25 mN/m to 35 mN/m, under an environment at 20°C so that the ink is smoothly supplied when an ink tank is exchanged. As a method for measuring the surface tension, the surface tension can be determined by measurement by a vertical plate method using a glass plate, under an environment at 20°C, using a surface tension measuring instrument manufactured by Kyowa Interface Science Co., Ltd.

Then, a writing implement including each ball described above was prepared to conduct a running test. The test is a test in which a writing instrument is retained in the state of being tilted at 70° with respect to a paper surface and is rotated to draw a circle having a diameter of 32 mm at a load of 100 gf (about 0.98 N), and a writing distance by the writing instrument is investigated using a tester that moves writing paper (JIS: P3201) at a speed of 4 m/min. Writing of a distance of about 10 cm is achieved by drawing one circle by the writing instrument. A distance from the leading end of a pen point to the leading end position of the ball was measured every 100 m of the writing distance. Since the distance from the leading end of the pen point to the leading end position of the ball was shortened due to wear of the ball and the ball holding portion, the change amount (depression amount) of the leading end position of the ball was regarded as a wear amount. Further, after the exhaustion of the ink filled in the ink tank, the ink tank was exchanged, and the running test was further continued.

As a result of measuring the wear amount mentioned above, the result of untreated ball (WC) on which no carbonaceous film was formed > carbonaceous film (DLC-0) into which no carbon-oxygen bond was introduced > DLC-1 > DLC-2 was obtained. This is considered to be because, when the carbonaceous film having a carbon-oxygen bond was formed, an affinity between the ball and the water-based ink was improved, direct contact between the ball and the ball holding portion hardly occurs, and therefore, the ball and the ball holding portion were inhibited from being worn, although boundary lubrication is considered to occur between the ball and the ball holding portion in the water-based ink. Further, DLC-0 resulted in a large wear amount and in nonuniform handwriting in the writing of 2000 m. In contrast, in DLC-1 and DLC-2, stable writing performance was able to be maintained even in the writing of 3000 m and 5000 m.

The specific change amount (depression amount) of the leading end position of the ball in DLC-1 was 0 $\mu$m in non-writing, 3 $\mu$m after 0-100 m writing, 4 $\mu$m after 500 m writing, or 5 $\mu$m after 1000 m writing. As a result of further exchanging a cartridge and performing continuous measurement, the amount was 5 $\mu$m after 1500 m writing, 6 $\mu$m after 2000 m writing, 7 $\mu$m after 3000 m writing, or 8 $\mu$m after 5000 m writing. Depending on the composition and viscosity of an ink, uniform handwriting is inhibited when the change amount (depression amount) of the leading end position of the ball is more than 10 $\mu$m.

In DLC-1, a wear amount of 3 $\mu$m after 0-100 m writing is slightly large; however, since this is because the ball and the ball holding portion conform to each other to form an abutting surface from a writing distance of 0 m to a writing distance of 100 m, and then, wear does not occur or only slight wear occurs due to the carbonaceous film, stable writing performance is satisfied for a long period.

Reference Signs List

| | |
|---|---|
| 1 | Writing instrument |
| 2 | Pen point |
| 21 | Pipe |
| 22 | Leading edge |
| 23 | Inwardly projecting portion |
| 24 | Ball |
| 24A | Ball body |
| 24B | Intermediate layer |
| 24C | Carbonaceous film |
| 3 | Pen point retaining member |
| 31 | Comb |
| 32 | Reservation groove |
| 33 | Guiding groove |
| 34 | Collar portion |
| 35 | Communication groove |
| 36 | Concave groove |
| 37 | Central hole |
| 4 | Ink tank |
| 41 | Plug body |
| 5 | Leading shaft |
| 51 | Threaded engagement portion |
| 51a | Male screw portion |
| 52 | Binding portion |
| 52a | Projection |
| 6 | Rear shaft |
| 61 | Female screw portion |
| 7 | Holder |
| 8 | Ink guiding member |
| 81 | First ink guiding member |
| 82 | Second ink guiding member |
| 83 | Third ink guiding member |

## Claims

1. A writing instrument comprising:

    a pen point retaining member;
    a pen point that comprises a ball and a ball holding portion that rotatably holds the ball, and is attached to a first end of the pen point retaining member; and
    an ink tank that is releasably attached to a second end of the pen point retaining member, the ink tank accommodating a water-based ink,
    wherein a carbonaceous film is formed on at least one of a surface of the ball or a contact portion of the ball holding portion with the ball,
    **characterized in that** the carbonaceous film comprises carbon and oxygen bound to the carbon,
    wherein a proportion of a bond containing oxygen to the total bonded carbon contained in the carbonaceous film is 0.1 or more and 0.5 or less.

2. The writing instrument according to claim 1, wherein the carbonaceous film is formed on both of the surface of the ball and the contact portion of the ball holding portion with the ball.

3. The writing instrument according to any one of claims 1 to 2, wherein a proportion of an $sp^3$ carbon-carbon bond to an $sp^2$ carbon-carbon bond, contained in the carbonaceous film, is 0.3 or more.


## Patentansprüche

1. Schreibgerät, umfassend:

    ein Halteelement für eine Stiftspitze;
    eine Stiftspitze, die eine Kugel und einen Kugelhalteabschnitt umfasst, der die Kugel drehbar hält, und die an einem ersten Ende des Halteelements der Stiftspitze befestigt ist; und
    einen Tintentank, der lösbar an einem zweiten Ende des Halteelements für die Stiftspitze befestigt ist, wobei der Tintentank eine Tinte auf Wasserbasis aufnimmt,
    wobei ein kohlenstoffhaltiger Film auf mindestens einer Oberfläche der Kugel oder einem Kontaktabschnitt des Kugelhalteabschnitts mit der Kugel ausgebildet ist,
    **dadurch gekennzeichnet, dass** der kohlenstoffhaltige Film an den Kohlenstoff gebundenen Kohlenstoff und Sauerstoff enthält,
    wobei ein Anteil einer Sauerstoff enthaltenden Bindung an dem gesamten gebundenen Kohlenstoff, der in dem kohlenstoffhaltigen Film enthalten ist, 0,1 oder mehr und 0,5 oder weniger beträgt.

2. Schreibgerät nach Anspruch 1, wobei der kohlenstoffhaltige Film sowohl auf der Oberfläche der Kugel als auch auf dem Kontaktabschnitt des Kugelhalteabschnitts mit der Kugel ausgebildet ist.

3. Schreibgerät nach einem der Ansprüche 1 bis 2, wobei ein Verhältnis einer $sp^3$-Kohlenstoff-Kohlenstoff-Bindung zu einer $sp^2$-Kohlenstoff-Kohlenstoff-Bindung, die in dem kohlenstoffhaltigen Film enthalten sind, 0,3 oder mehr beträgt.


## Revendications

1. Dispositif d'écriture comprenant :

    un élément de retenue de plume ;
    une plume qui comporte une bille et une partie de retenue de bille qui maintient la bille avec possibilité de rotation, et est fixée sur une première extrémité de l'élément de retenue de plume ; et
    un réservoir d'encre qui est fixé de manière amovible sur une seconde extrémité de l'élément de retenue de plume, le réservoir d'encre contenant une encre à base d'eau,
    dans lequel un film carboné est formé sur au moins l'une d'une surface de la bille ou d'une partie de contact de la partie de retenue de bille avec la bille,
    **caractérisé en ce que** le film carboné comprend du carbone et de l'oxygène lié au carbone,

EP 2 821 244 B1

dans lequel une proportion de liaisons contenant de l'oxygène sur le total de carbone lié contenu dans le film carboné est supérieure ou égale à 0,1 et inférieure ou égale à 0,5.

2. Dispositif d'écriture selon la revendication 1, dans lequel le film carboné est formé à la fois sur la surface de la bille et la partie de contact de la partie de retenue de bille avec la bille.

3. Dispositif d'écriture selon l'une quelconque des revendications 1 et 2, dans lequel une proportion de liaisons carbone-carbone $sp^3$ sur les liaisons carbone-carbone $sp^2$, contenues dans le film carboné, est supérieure ou égale à 0,3.

EP 2 821 244 B1

[Fig.1]

EP 2 821 244 B1

[Fig.2]

35    81
37
34    5

[Fig.3]

21
83
23
23
22
24A
24B
24C
24

13

[Fig.4]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005324336 A
- JP 2004338134 A
- JP 2010240931 A